# EUROPÄISCHE PATENTSCHRIFT

(11) **EP 2 893 053 B1**
(45) Veröffentlichungstag und Bekanntmachung des Hinweises auf die Patenterteilung: **12.10.2022**
(21) Anmeldenummer: 13802873.3
(22) Anmeldetag: 09.09.2013
(51) Int. Cl.: C23C 14/06, C23C 14/34, C23C 14/32, H01J 37/34, C01B 32/907

(54) **VERFAHREN ZUR HERSTELLUNG EINER METALLBOROCARBIDSCHICHT AUF EINEM SUBSTRAT**
PROCESS FOR PRODUCING A METALLIC BOROCARBIDE LAYER ON A SUBSTRATE
PROCÉDÉ DE PRODUCTION D'UNE COUCHE DE BOROCARBURE MÉTALLIQUE SUR UN SUBSTRAT

(30) Priorität: 10.09.2012 DE 102012017809
(43) Veröffentlichungstag der Anmeldung: 15.07.2015
(73) Patentinhaber: Oerlikon Surface Solutions AG, Pfäffikon, 8808 Pfäffikon SZ (CH)
(72) Erfinder: ARNDT, Mirjam, 35580 Wetzlar (DE); RUDIGIER, Helmut, 7000 Chur (CH); BOLVARDI, Hamid, 2545 Selzach (CH); SCHNEIDER, Jochen, 52066 Aachen (DE)
(74) Vertreter: Troesch Scheidegger Werner AG
(86) Internationale Anmeldenummer: PCT/EP2013/002700
(87) Internationale Veröffentlichungsnummer: WO 2014/053209

(56) Entgegenhaltungen:
- DE-A1-102008 020 163
- HÄSEHASE K ET AL: "Preparation of c-axis fibre textured thin films by pulsed laser deposition: film structure and superconducting properties", IEEE TRANSACTIONS ON APPLIED SUPERCONDUCTIVITY, IEEE SERVICE CENTER, LOS ALAMITOS, CA, US, Bd. 11, Nr. 1, 1. März 2001 (2001-03-01), Seiten 3836-3839, XP011091171, ISSN: 1051-8223, DOI: 10.1109/77.919901
- EMMERLICH J ET AL: "A proposal for an unusually stiff and moderately ductile hard coating material: Mo2BC", JOURNAL OF PHYSICS D: APPLIED PHYSICS, INSTITUTE OF PHYSICS PUBLISHING LTD, GB, Bd. 42, Nr. 18, 21. September 2009 (2009-09-21), Seite 185406, XP020163389, ISSN: 0022-3727, DOI: 10.1088/0022-3727/42/18/185406
- LIU M Y ET AL: "The Effect of Deposition Temperature and Work Pressure on Tiâ Bâ C Nanocomposite Coating Prepared by Multitarget Magnetron Cosputtering", IEEE TRANSACTIONS ON PLASMA SCIENCE, IEEE SERVICE CENTER, PISCATAWAY, NJ, US, Bd. 39, Nr. 11, 1. November 2011 (2011-11-01), Seiten 3115-3119, XP011362235, ISSN: 0093-3813, DOI: 10.1109/TPS.2011.2162081
- LIN, JIANLIANG; PARK, IN-WOOK: "Processing, Structure, and Properties of Nanostructured Multifunctional Tribological Coatings", JOURNAL OF NANOSCIENCE AND NANOTECHNOLOGY, Bd. 9, Nr. 7, 1. Juli 2009 (2009-07-01), Seiten 4073-4084, XP008167529,
- LIN J ET AL: "Structure and properties of Ti-B-C-N nanocomposite coatings synthesized using pulsed closed field unbalanced magnetron sputtering (P-CFUBMS)", SURFACE AND COATINGS TECHNOLOGY, ELSEVIER, AMSTERDAM, NL, Bd. 203, Nr. 5-7, 25. Dezember 2008 (2008-12-25), Seiten 588-593, XP025656879, ISSN: 0257-8972, DOI: 10.1016/J.SURFCOAT.2008.06.083 [gefunden am 2008-06-17]
- ARISAWA S ET AL: "SYNTHESIS OF YNI2B2C THIN FILMS BY MAGNETRON SPUTTERING", APPLIED PHYSICS LETTERS, AMERICAN INSTITUTE OF PHYSICS, US, Bd. 65, Nr. 10, 5. September 1994 (1994-09-05), Seiten 1299-1301, XP000464623, ISSN: 0003-6951, DOI: 10.1063/1.112100
- REIBOLD M ET AL: "Epitaxial growth of YNi2B2C films on single crystal MgO substrates: an HRTEM investigation of the interface", JOURNAL OF ALLOYS AND COMPOUNDS, ELSEVIER SEQUOIA, LAUSANNE, CH, Bd. 347, Nr. 1-2, 16. Dezember 2002 (2002-12-16), Seiten 24-30, XP004392715, ISSN: 0925-8388, DOI: 10.1016/S0925-8388(02)00753-3
- FERDEGHINI C ET AL: "In situ deposition of ErNi"2B"2C films by pulsed laser ablation technique", PHYSICA C, NORTH-HOLLAND PUBLISHING, AMSTERDAM, NL, vol. 299, no. 1-2, 10 April 1998 (1998-04-10), pages 15-22, XP004130338, ISSN: 0921-4534, DOI: 10.1016/S0921-4534(98)00047-1

## Beschreibung

Die vorliegende Erfindung betrifft das Abscheiden einer Metallborocarbidschicht auf einem Substrat mittels eines gepulsten PVD-Verfahrens. Dabei handelt es sich vorzugsweise um ein gepulstes Käthoden-Zerstäubungsverfahren, wobei das das von der Kathode zerstäubte Material als Beschichtungsmaterial aus der Gasphase auf dem Substrat abgeschieden wird.

Metallborocarbidmaterialien sind aufgrund ihrer ausgezeichneten mechanischen und chemischen Eigenschaften als Grundkörpermaterial eingesetzt. Hierfür sind unterschiedlichste Herstellungsmethoden bekannt auf die im Folgenden nicht näher eingegangen werden soll. Allerdings sind diese Materialien teuer in der Herstellung und problematisch in der Bearbeitung.

Ein diesbezüglich gangbarer Weg ist die Vergütung von Komponenten deren Grundkörper aus herkömmlichen Materialien wie zum Beispiel Cermet, Stahl, Hartmetall oder Schnellarbeitsstahl aufgebaut ist Eine solche Vergütung kann dabei auch eine Beschichtung mit einer Metallborocarbidschicht umfassen. Dabei kann auf PVD-Verfahren zurückgegriffen werden PVD steht in diesem Zusammenhang für physical vapor deposition und bedeutet Abscheidung aus der Gasphase. Schier erwähnt in der Anmeldung WO2012/052437 das Sputter PVD Verfahren und insbesondere das HIPIMS Verfahren. HIPIMS steht hierbei für High Power Impuls Magnetron Sputtern, welches ein Sputterverfahren ist, bei dem unter Zuhilfenahme eines Magnetrons und mit einer hohen Stromdichte von der Kathode zerstäubt wird. Schier beschreibt das Sputtern als nachteilig, weil der notwendige Prozessgasfluss schwierig zu regeln sei. Ausserdem gibt es Schwierigkeiten, die für die Beschichtung gewünschte kristalline Phase zu erzeugen, wie Schier am Beispiel des Aluminiumoxides schildert.

Daher wird in der WO2012/052437 ein Lichtbogenverfahren (arc PVD) zur Abscheidung solcher Schichten beschrieben. Bei diesem Verfahren wird ein Lichtbogen aufrecht erhalten, dessen Brennfleck auf dem das Beschichtungsmaterial liefernde sogenannte Target wandert und dabei Targetmaterial verdampft. Als Targetmaterial kommt ein Target zum Einsatz welches mindestens zwei verschiedene Metalle umfasst und wobei wenigstens das Metall mit der niedrigsten Schmelztemperatur in dem Target in einer keramischen Verbindung vorliegt. Auf diese Weise soll die mit der arc PVD häufig einhergehende Droptetbildung unterdrückt werden. Allerdings gelingt dies nicht vollständig. Will man daher im Wesentlichen dropletfrei beschichten, so sind bisher bei den arc PVD Verfahren aufwändige Filtertechniken notwendig, die allerdings die Beschichtungsrate signifikant verringern und die Technologie teilweise unwirtschaftlich werden lassen.

Borocarbide der seltenden Erden sind derzeit als interessantes Supraleitendes Material bekannt. In ihrem Artikel "Borocarbide "Thin Films And Tunneling Measurements" welcher 2000 im Rahmen eine NATO workshops in Dresden veröffentlicht wurde beschreiben lavarone et al Magnetron-Sputtern als Verfahren zur Herstellung von Re-Ni₂B₂C, wobei Re ein Element aus der Gruppe gebildet durch Y, Er, Lu ist. Das Sputterverfahren wurde bei ca. 800°C angewandt und es mussten Diamantsubstrate verwendet werden.

J. Emmerlich et al.: "A proposal for an unusually stiff and moderately ductile coating material: Mo2BC", beschreibt die Herstellung von Mo₂BC Filmen durch Magnetron Sputtern bei Substrat-Temperaturen von ~900°C.

Weiterer relevanter Stand der Technik ist offenbart in EMMERLICH J ET AL: "A proposal for an unusually stiff and moderately ductile hard coating material: Mo2BC",JOURNAL OF PHYSICS D: APPLIED PHYSICS, INSTITUTE OF PHYSICS PUBLISHING LTD, GB, Bd. 42, Nr. 18, 21. September 2009 (2009-09-21), Seite 185406, XP020163389,ISSN: 0022-3727, DOI: 10.1088/0022-3727/42/18/185406.

Es wäre daher wünschenswert ein Verfahren zur Verfügung zu haben welches erlaubt bei moderaten Temperaturen wirtschaftlich Schichten von Metallborocarbide auf Substraten abzuscheiden, wobei die Schichten zu einem beträchtlichen Teil gewünschte vorzugsweise mikro- und/oder nanokristalline Phasen enthalten sollten.

Es ist daher die Aufgabe der vorliegenden Erfindung ein solches Verfahren anzugeben.

Die Erfindung betrifft ein Verfahren zur Beschichtung eines Substrates gemäss Anspruch 1 und ein beschichtetes Werkzeug gmäss Anspruch 8.

Somit betrifft die Erfindung ein HIPIMS-Verfahren zur Beschichtung eines Substrates mit einer zumindest eine mikrokristalline Metallborocarbid-Phase enthaltende Schicht, wobei es sich bei dem Metallborocarbid um ein Material gemäss der Formel Me₂BC handelt. Im Rahmen des HIPIMS-Verfahrens wird die Quellenleistung dergestalt gepulst, dass das im Röntgensprektrum einer derart bei einer Substrattemperatur unterhalb 600°C hergestellten Schicht zumindest ein Peak identifiziert werden kann, dessen Halbwertsbreite auf das vorhanden sein einer mikrokristallinen Phase des Metallborocarbides schliessen lässt.

Beispielsweise wird die Aufgabe dadurch gelöst, dass ein gepulstes HIPIMS-Verfahren zur Anwendung kommt. Im Zusammenhang mit dem arc PVD Verfahren erhöht das Pulsen die Prozessstabilität und reduziert die Dropletbildung signifikant. Im Zusammenhang mit dem Sputtern wird durch das Pulsen der lonisierungsgrad im Vergleich zum herkömmlichen Sputtern deutlich erhöht ist. Die Erfinder haben festgestellt, dass sich erstaunlicher weise durch das Pulsen bereits bei Substrattemperaturen unterhalb 600°C mikrokristalline Phasen von Metallborocarbiden bilden können. Dies ist bis zu einem gewissen Grad bereits durch eine gepulste, wenn auch Sputterleistung welche zu moderaten Stromdichten kleiner gleich 100W/cm² erreichbar wenn ein Target zur Verwendung kommt, in dem das Metall in einer keramischen Verbindung vorliegt.

Vorzugsweise wird aber ein sogenannte HIPIMS-Technik eingesetzt, bei dem Stromdichten an der Targetoberfläche zum Einsatz kommen welche grösser als 100W/cm² sind. Solche Stromdichten werden ebenfalls als Puls appliziert um das Target nicht übermässig zu erhitzen. Mittels des HIPIMS Verfahren, so haben die Erfinder herausgefunden lassen sich kristalline Phasen von Metallborocarbiden auch bereits mittels Targets erzeugen, in welchen das Metall nicht als Keramikverbindung vorliegt. Vorzugsweise wird jedoch auch wenn das HIPIMS-Verfahren zum Einsatz kommt von einem Target zerstäubt in dem das Metall in einer keramischen Verbindung vorliegt und insbesondere als Metallborocarbid vorliegt.

Gemäss einer besonders bevorzugten Ausführungsform der vorliegenden Erfindung wird an die Substrate während der HIPIMS-Verfahrens ein negativer Bias angelegt. Dieser liegt zwischen -30V und -400V, wobei die betragsmässige Obergrenze unter anderem dadurch bestimmt wird, dass die Temperatur der Substratoberfläche mit zunehmendem Bias, was aufgrund der beschleunigten Ionen zu einem zunehmenden Energieeintrag führt.

Aufgrund der Bildung der mikrokristallienen Phasen bereits unter 600°C kann das erfindungsgemässe Verfahren wirtschaftlich industriel eingesetzt werden, da keine zusätzlichen technischen Massnahmen getroffen werden müssen um etwa die Beschichtungsanlagen hochtemperaturverträglich (>600°C) auszugestalten. Insbesondere lässt sich das Verfahren besonders vorteilhaft im Rahmen der Beschichtung von Substraten einsetzen welche selbst keiner hohen Temperatur ausgesetzt werden dürfen. Prominentes Beispiel hierfür ist HSS Stahl.

Von besonderem Interesse unter den Metallborocarbid Materialien sind diejenigen, welche mit den Halbmetallen gebildet werden. Für Supraleitermaterialien sind diejenigen Metallborocarbide interessant, in denen zumindest ein Element der seltenen Erden vorkommt. Für Vergütungen weiche Verschleissschutz bieten sollen und/oder zu einer Oberfläche mit niedrigen Reibwerten führen sollen haben sich die Borocarbide der Übergangsmetalle und insbesondere der Elemente aus der Gruppe gebildet durch Ti, Zr, Hf, V, Nb, Ta, Cr, Mo und W als besonders geeignet herausgestellt. Vorzugsweise wird Mo, Zr und/oder Cr verwendet. Solche Vergütungen können insbesondere bei Werkzeugen und Komponenten aus dem Automotive Bereich mit Gleitflächen vorteilhaft eingesetzt werden.

Die Erfindung wird nun Beispielhaft im Detail anhand der Figuren und mit Hilfe von Mo₂BC erläutert.

Zunächst wurde zu Vergleichszwecken Mo2BC in einer kleinen Beschichtungskammer mittels DC Sputtern beschichtet. Die entsprechenden Beschichtungsparameter sind:

| Generator: | DC |
|---|---|
| Leistun | 50W |
| Target: | 50mm Verbund target |
| Substrattemperaturen: | 300-700° C |
| Basisdruck: | × 10 ₋₅ mbar |

Betrachtet werden der Substrat Temperatur Effekt, die Rauhigkeit, die Härte und das Elastizitätsmodul.

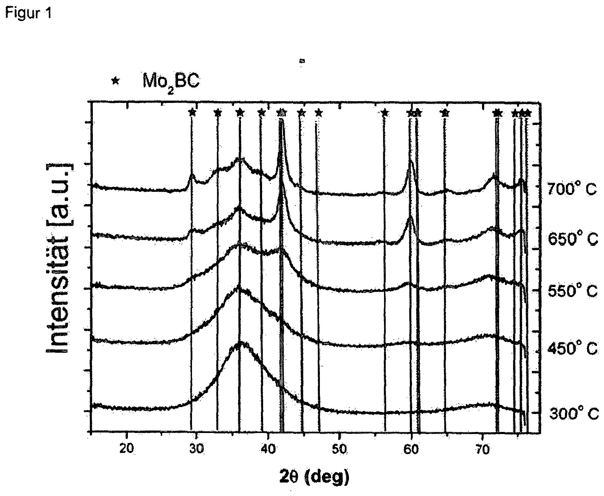

Die Beschichtungen wurde bei unterschiedlichen Temperaturen durchgeführt, Figur 1 zeigt jeweils ein Röntgenbeugungsspektrum (2 theta) für mit 300°C, 450°C, 550°C, 650°C und 700°C Substrattemperatur beschichtete Oberflächen. Dabei wird deutlich, dass erst oberhalb von 600°C vom Vorhandensein von kristallinen Phasen ausgegangen werden kann. Unterhalb 550°C Ts liegen amoprhe oder nanokristalline Phasen vor. Sowohl das Elastizitätsmodul als auch die Härte nehmen mit abnehmender Substrattemperatur zu.

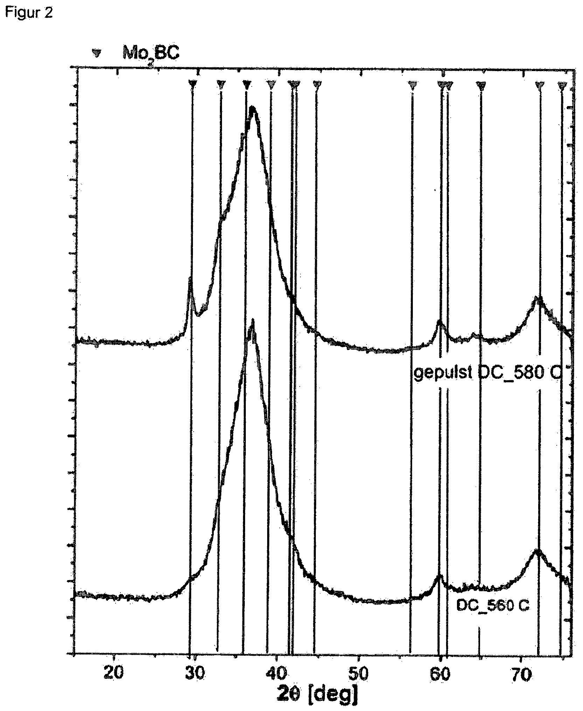

Demgegenüber wurde bei einer Beschichtung mit gepulster Leistung bereist bei 580°C deutliche Peaks gemessen, wie der Vergleich in Figur 2 zeigt. Dabei handelt es sich um gepulstes Magnetron Zerstäuben. Die höhere Plasmadichte im gepulsten der höhere lonenbeschuss und die höhere Beweglichkeit der Adatome führt zu einem höheren Grad der Phasenbildung.

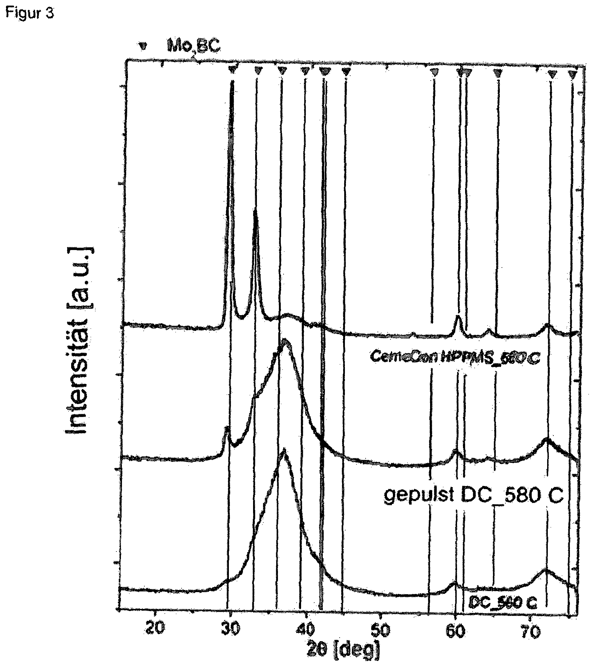

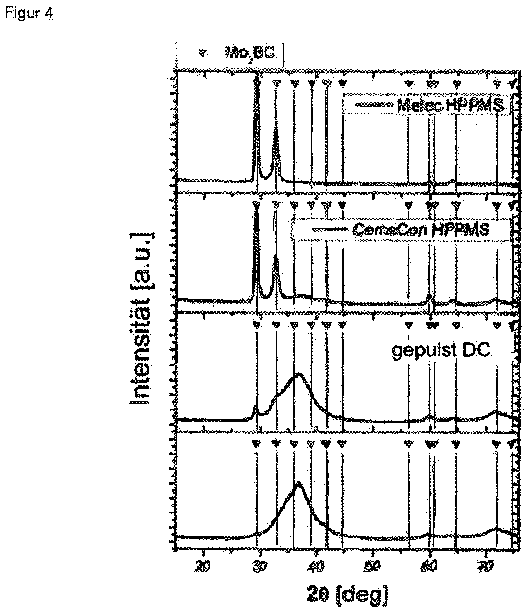

Vorherrschend ist die kristalline Phase bereits bei einer Substrattemperatur von 580°C wenn HIPIMS eingesetzt wird, wie die Figur 3 deutlich zeigt. In dem Zusammenhang bedeuten HPPMS und HIPIMS dasselbe Verfahren. Diesführt zum höchsten Grad der Kristallisation und zu texturierter Struktur. In Figur 4 sind die Röntgenspektren unterschiedlicher Verfahren mit ähnlicher Substrattemperatur (560°C bis 580°C) abgebildet. Die HIPIMS Beschichtungen wurden mit zwei unterschiedlichen kommerziellen Quellen durchgeführt. Dasselbe Temperaturverhalten zeigt sich bei der Beschichtung von Stahlsubstraten. Die Substratwahl hat in diesem Fall also keinen Einfluss.

Unterhalb von 600°C Substrattemperatur hat beim ungepulsten DC Sputtern ein angelegter Substratbias von -100V keinen merklichen Effekt auf die Phasenbildung hat. Demgegenüber zeigen sich kristalline Phasen des Mo₂BC spätestens bereits bei 480°C Substrattemperatur wenn ein HiPIMS-Verfahren zur Anwendung kommt und gleichzeitig ein negative Bias von z.B. -100V an das Substrat angelegt wird.

Es wurde ein PVD-Verfahren zur Beschichtung eines Substrates mit einer zumindest eine mikrokristalline Metaltborocarbid-Phase enthaltende Schicht offenbart wobei das Verfahren dadurch gekennzeichnet ist, dass im Rahmen des PVD-Verfahrens die Quellenleistung gepulst wird dergestalt, dass das im Röntgensprektrum einer derart bei einer Substrattemperatur unterhalb 600°C hergestellten Schicht zumindest ein Peak identifiziert werden kann, dessen Halbwertsbreite auf das vorhanden sein einer mikrokristallinen Phase des Metallborocarbides schliessen lässt.

Bei dem Verfahren kann es sich um ein gepulstes arc PVD-Verfahren handeln, vorzugsweise handelt es sich jedoch um ein gepulstes Sputterverfahren.

Das erfindungsgemässe Sputterverfahren kann zumindest teilweise mit einer Stromdichte von grösser als 100W/cm² als HIPIMS-Verfahren betrieben werden.

Das erfindungsgemässe PVD-Verfahren kann mit einem Target betrieben werden, in welchem ein Metall als keramische Verbindung, beispielsweise als Metallborökarbid vorliegt

Beim erfindungsgemässen Verfahren kann es sich bei dem Metallborocarbid um ein Material gemäss der Formel Me₂BC handeln, wobei Me ein Element aus der Gruppe gebildet durch Cr, Zr und Mo ist.

Das Verfahren kann so durchgeführt werden dass der zumindest eine Peak mindestens eine doppelt so grosse Amplitude wie die grösste Amplitude eines auf eine nanokristalline und/oder amorphe Phase hinweisende Messwert eines von 20° bis 70° gemessenen 2Theta Röntgensprektrums besitzt. Dies kann beispielsweise durch einen entsprechend gewählten Substratbias bei einem HIPIMS-Verfahren erreicht werden, wie die Figuren zeigen.

Mit dem neuen Verfahren kann ein mit einer Metallborocarbidbeschichtung hergestellt werden bei welchem im Röntgensprektrum der Beschichtung zumindest ein Peak identifiziert werden kann, dessen Halbwertsbreite auf das vorhanden sein einer mikrokristallinen Phase des Metallborocarbides schliessen lässt.

Es kann sich bei dem Metallborocarbid um ein Material gemäss der Formel Me₂BC handeln, wobei Me ein Element aus der Gruppe gebildet durch Cr, Zr und Mo ist.

## Patentansprüche

1. HIPIMS-Verfahren zur Beschichtung eines Substrates mit einer zumindest eine mikrokristalline Metallborocarbid-Phase enthaltende Schicht, wobei es sich bei dem Metallborocarbid um ein Material gemäss der Formel Me₂BC handelt,
**dadurch gekennzeichnet, dass** im Rahmen des HIPIMS-Verfahrens die Quellenleistung gepulst wird dergestalt, dass das im Röntgensprektrum einer derart bei einer Substrattemperatur unterhalb 600°C hergestellten Schicht zumindest ein Peak identifiziert werden kann, dessen Halbwertsbreite auf das vorhanden sein einer mikrokristallinen Phase des Metallborocarbides schliessen lässt.

2. Verfahren nach Anspruch 1, **dadurch gekennzeichnet, dass** das HIPIMS-Verfahren zumindest teilweise mit einer Stromdichte von grösser als 100W/cm² betrieben wird.

3. Verfahren nach einem der vorangehenden Ansprüche, **dadurch gekennzeichnet, dass** das PVD-Verfahren mit einem Target betrieben wird, in welchem ein Metall als keramische Verbindung vorliegt.

4. Verfahren nach Anspruch 3, **dadurch gekennzeichnet, dass** die keramische Verbindung ein Metallborokarbid ist.

5. Verfahren nach einem der vorhergehenden Ansprüche, **dadurch gekennzeichnet, dass** während des PVD-Verfahrens zumindest teilweise ein negativer Bias an das zu beschichtende Substrat angelegt wird.

6. Verfahren nach einem der vorhergehenden Ansprüche, **dadurch gekennzeichnet, dass** es sich bei dem Metallborocarbid um ein Material gemäss der Formel Me₂BC handelt, wobei Me ein Element aus der Gruppe gebildet durch Cr, Zr und Mo ist.

7. Verfahren nach einem der vorangehenden Ansprüche, **dadurch gekennzeichnet, dass** das Verfahren so durchgeführt wird, dass der zumindest eine Peak mindestens eine doppelt so grosse Amplitude wie die grösste Amplitude eines auf eine nanokristalline und/oder amorphe Phase hinweisende Messwert eines von 20° bis 70° gemessenen 2Theta Röntgensprektrums besitzt.

8. Werkstück mit einer Metallborocarbidbeschichtung im Röntgensprektrum der Beschichtung zumindest ein Peak identifiziert werden kann, dessen Halbwertsbreite auf das vorhanden sein einer mikrokristallinen Phase des Metallborocarbides schliessen lässt,
**dadurch gekennzeichnet, dass** es sich bei dem Metallborocarbid um ein Material gemäss der Formel Me₂BC handelt, wobei Me ein Element aus der Gruppe gebildet durch Cr und Zr ist.

## Claims

1. HIPIMS process for coating a substrate with a layer containing at least one microcrystalline metal borocarbide phase, wherein the metal borocarbide is a material according to the formula Me₂BC,
**characterized in that** in the HIPIMS process the source power is pulsed in such a way that in the X-ray spectrum of a layer thus produced at a substrate temperature below 600°C at least one peak can be identified whose half-value width indicates the presence of a microcrystalline phase of the metal borocarbide.

2. Process according to claim 1, **characterized in that** the HIPIMS process is at least partially operated with a current density of greater than 100W/cm².

3. Process according to one of the preceding claims, **characterized in that** the PVD process is operated with a target in which a metal is present as a ceramic compound.

4. Process according to claim 3, **characterized in that** the ceramic compound is a metal borocarbide.

5. Process according to one of the preceding claims, **characterized in that** during the PVD process a negative bias is at least partially applied to the substrate to be coated.

6. Process according to one of the preceding claims, **characterized in that** the metal borocarbide is a material according to the formula Me₂BC, wherein Me is an element selected from the group formed by Cr, Zr and Mo.

7. Process according to one of the preceding claims, **characterized in that** the process is carried out in such a way that the at least one peak has at least twice as large an amplitude as the largest amplitude of a measured value of a 2Theta X-ray spectrum measured from 20° to 70°, the measured value indicating a nanocrystalline and/or amorphous phase.

8. Workpiece having a metal borocarbide coating, at least one peak whose half-value width indicating the presence of a microcrystalline phase of the metal borocarbide can be identified in the X-ray spectrum of the coating, **characterized in that** the metal borocarbide is a material according to the formula Me₂BC, wherein Me is an element from the group formed by Cr and Zr.

## Revendications

1. Procédé HIPIMS pour revêtir un substrat avec une couche contenant au moins une phase microcristalline de carbure de bore métallique, le carbure de bore métallique étant un matériau suivant la formule Me₂BC, **caractérisé en ce que**, dans le cadre du procédé HIPIMS, la source d'énergie pulsée est telle que dans le spectre de rayons X d'une couche fabriquée à une température de substrat inférieure à 600°C, il est possible d'identifier au moins un pic dont la largeur à mi-hauteur laisse supposer la présence d'une phase microcristalline du carbure de bore métallique.

2. Procédé selon la revendication 1, **caractérisé en ce que** le procédé HIPIMS est utilisé au moins en partie avec une densité de courant supérieure à 100W/cm².

3. Procédé selon l'une des revendications précédentes, **caractérisé en ce que** le procédé PVD est utilisé avec une cible dans laquelle est présent un métal comme composé céramique.

4. Procédé selon la revendication 3, **caractérisé en ce que** le composé céramique est un carbure de bore métallique.

5. Procédé selon l'une des revendications précédentes, **caractérisé en ce que**, pendant le procédé PVD, une polarisation négative est au moins en partie appliquée sur le substrat à revêtir.

6. Procédé selon l'une des revendications précédentes, **caractérisé en ce que** le carbure de bore métallique est un matériau suivant la formule Me₂BC, Me étant un élément du groupe formé par Cr, Zr et Mo.

7. Procédé selon l'une des revendications précédentes, **caractérisé en ce que** le procédé est réalisé de sorte que le au moins un pic possède une amplitude au moins deux fois plus grande que la plus grande amplitude d'une valeur de mesure d'un spectre de rayons X 2thêta mesuré entre 20° et 70°, la valeur de mesure indiquant une phase nanocristalline et/ou amorphe.

8. Pièce à usiner avec un revêtement en carbure de bore métallique, au moins un pic pouvant être identifié dans le spectre de rayons X du revêtement, dont la largeur à mi-hauteur laisse supposer la présence d'une phase microcristalline du carbure de bore métallique, **caractérisée en ce que** le carbure de bore métallique est un matériau suivant la formule Me₂BC, Me étant un élément du groupe composé de Cr et Zr.
